# EUROPEAN PATENT APPLICATION

(11) **EP 4 534 741 A1**
(43) Date of publication of application: **09.04.2025**
(21) Application number: 23815543.6
(22) Date of filing: 28.03.2023
(51) Int. Cl.: C30B 29/38, C30B 25/18, H01L 21/205

(54) **METHOD FOR MANUFACTURING GROUP III NITRIDE SINGLE CRYSTAL SUBSTRATE**

(30) Priority: 03.06.2022 JP 2022091159
(71) Applicant: SHIN-ETSU CHEMICAL CO., LTD., Tokyo 1000005 (JP)
(72) Inventor: KUBOTA, Yoshihiro, Annaka-shi, Gunma 379-0195 (JP)
(74) Representative: Vossius & Partner Patentanwälte Rechtsanwälte mbB
(86) International application number: PCT/JP2023/012426
(87) International publication number: WO 2023/233781

(57) **Abstract**

The method for manufacturing group III nitride single crystal substrate that can shorten the device fabrication time and suppress cracking and property degradation during fabrication is provided.

The method for manufacturing group III nitride single crystal substrate according to the present invention performs: a support substrate preparation step for preparing a support substrate containing nitride ceramics; a planarizing layer formation step for forming a planarizing layer on the top surface of the support substrate; a seed crystal layer formation step for forming a seed crystal layer on the top surface of the planarizing layer; an epitaxial deposition step for epitaxially growing a target group III nitride single crystal on the top surface of the seed crystal layer to form a composite substrate; and a separation step for separating the group III nitride single crystal substrate made of the group III nitride single crystal from the remaining section of the composite substrate by removing at least one of the planarizing layer and the seed crystal layer.

## Description

### TECHNICAL FIELD

The present invention relates to a method for manufacturing group III nitride single crystal substrate such as aluminum nitride (AlN), aluminum gallium nitride (AlₓGa₁₋ₓN (0 < x < 1.0)), gallium nitride (GaN) and the like. Specifically, it relates to a method for manufacturing group III nitride single crystal substrate in which group III nitride-based solid substrate is manufactured by epitaxial deposition with high characteristics and low cost.

### BACKGROUND ART

Group III nitride substrates such as crystalline AlN-based substrates and GaN-based substrates have a wide band gap and excellent high-frequency characteristics with short wavelength emission and high breakdown voltage. Therefore, the group III nitride substrates are expected to find applications in devices such as light-emitting diodes (LEDs), lasers, Schottky diodes, power devices, and high-frequency devices. In particular, LEDs fabricated from the single crystal of AlN and AlxGa1-xN (0.5 < x < 1.0) have been reported to have bactericidal effects in the emission wavelength of the deep ultraviolet range (UVC; 200-280 nm) (see Non-Patent Document 1) and is expected to be used as a device against coronavirus infections. In addition, GaN single crystal is expected to be used as a device for 5G and 6G wireless stations and for wireless charging of EVs, and further improvements in quality, larger diameter, and lower cost are required.

Since AlN does not have a melting point under normal pressure, it is difficult to manufacture AlN by the melt method commonly used to manufacture silicon single crystals and other materials. With such circumstances in the background, Non-Patent Document 2 and Non-Patent Document 3 describe a method for manufacturing AlN single crystal substrates by the sublimation method (modified Lely method) using SiC or AlN as seed crystal under N₂ atmosphere at 1700 to 2250°C. However, due to the high temperatures required for crystal growth and a large apparatus involved, it was difficult to reduce the cost, and was also difficult to achieve a large diameter of φ 4 inches or larger. Patent Document 1 describes a method for growing an AlN layer by using a hydride vapor deposition (HVPE) method using a silicon substrate or an AlN substrate as a support substrate.

However, since the method in Patent Document 1 uses silicon or the like as the support substrate, it is difficult to reduce the dislocation density of the AlN layer due to differences in thermal expansion coefficient and lattice constant. Although it is possible to use a sublimation AlN substrate with excellent crystallinity as a support substrate, the support substrate itself has a small diameter and is expensive. Thus, it is difficult to increase the diameter of the substrate and reduce the cost of the substrate.

On the other hand, a method for manufacturing GaN substrates is described in Patent Document 2. In this manufacturing method, AlN ceramics, whose thermal expansion coefficient and lattice constant are relatively close to those of GaN single crystal, are used as the core, and the core is encapsulated with a multilayer film of SiO₂, Si₃N₄, or the like to serve as the support substrate. Then, a planarizing layer such as SiO₂ is formed to fill in the unevenness of the support substrate. Then, a seed crystal of silicon <111> single crystal is thinly transferred onto the planarizing layer to form a composite substrate, and single crystals such as GaN are epitaxially grown on the seed crystal to deposit a film.

However, when the single crystal of GaN, AlN, or AlₓGa₁₋ₓN (0 < x < 1) is epitaxially deposited thickly in this manufacturing method, for example, it is difficult to reduce the dislocation density because of the large difference in lattice constant between the silicon < 111 > seed crystal and the GaN, AlN, or AlₓGa₁₋ₓN (0 < x < 1) single crystal. In addition, due to mutual affinity and differences in thermal expansion coefficients between AlN ceramics and encapsulating layers, between the multilayer films, and between the multilayer films and the planarizing layer, the manufactured group III nitride single crystal substrate is likely to crack, warp, or suffer other problems. Furthermore, the manufactured group III nitride single crystal substrate is usually thinned by back grinding to make it thinner after device fabrication. At this time, unlike semiconductors such as Si, the support substrate containing the hard and easily cracked AlN ceramic core is subjected to grinding, which requires a long processing time, and is likely to cause resource loss due to cracking, resulting in lower device yield and characteristic degradation, which is a major drawback in the manufacturing of group-III nitride single crystal substrates.

### PRIOR ART DOCUMENTS

### PATENT DOCUMENTS

Patent Document 1: JP4565042B
Patent Document 2: JP6626607B

### NON-PATENT DOCUMENTS

Non-Patent Document 1: LEDs Magazine Japan; December 2016, pp. 30-31
Non-Patent Document 2: SEI Technical Review; No. 177, pp. 88-91
Non-Patent Document 3: Fujikura Technical Review; No. 119, 2010, Vol. 2, pp. 33-38

### SUMMARY OF THE INVENTION

### PROBLEMS TO BE SOLVED BY THE INVENTION

The present invention was made in view of the above circumstances, and it is an object to provide a method for manufacturing group-III nitride single crystal substrate that can shorten the device fabrication time and suppress cracking and characteristic degradation during device fabrication.

### MEANS FOR SOLVING THE PROBLEMS

The method for manufacturing group III nitride single crystal substrate according to the present invention performs: a support substrate preparation step for preparing a support substrate containing nitride ceramics; a planarizing layer formation step for forming a planarizing layer on the top surface of the support substrate; a seed crystal layer formation step for forming a seed crystal layer on the top surface of the planarizing layer; an epitaxial deposition step for epitaxially growing a target group III nitride single crystal on the top surface of the seed crystal layer to form a composite substrate; and a separation step for separating the group III nitride single crystal substrate made of the group III nitride single crystal from the remaining section of the composite substrate by removing at least one of the planarizing layer and the seed crystal layer.

The removal of at least one of the planarizing layer and the seed crystal layer may be performed by melting using high-frequency induction heating.

The removal of at least one of the planarizing layer and the seed crystal layer may be performed by dry etching with an etching gas for Si-based compound and/or an etching gas for group III nitride.

A stress adjusting layer formation step for forming a stress adjusting layer on the bottom surface of the support substrate may be further performed.

The stress adjusting layer may include silicon.

The nitride ceramics may be either AlN-based, GaN-based, or Si₃N₄-based.

The support substrate may have a structure in which a core consisting of nitride ceramics is wrapped in an encapsulating layer with a thickness of 0.05 µm or more to 1.5 µm or less.

The encapsulating layer may include at least one of Si₃N₄ and SiOₓN_{y} (where x = 1, 1 ≤ y ≤ 20) .

The planarizing layer may include at least one of SiO₂ and SiOₓN_{y} (where 1 ≤ x ≤ 20, y = 1) .

The thickness of the planarizing layer may be 0.5 µm or more and 3.0 µm or less.

The thickness of the seed crystal layer may be 0.04 µm or more and 1.50 µm or less.

The seed crystal layer may be a Si <111> single crystal.

Si <111> single crystal may have a resistivity of 100 Ω-cm or higher at 20°C.

The seed crystal layer may be a group III nitride single crystal.

### EFFECTS OF THE INVENTION

The method for manufacturing group III nitride single crystal substrate of the present invention can shorten the device fabrication time and suppress cracking and property degradation during the device fabrication.

### BRIEF DESCRIPTION OF THE DRAWINGS

Fig. 1 is a diagram showing the flow of the method for manufacturing group-III nitride single crystal substrate of the present invention.
Fig. 2 is a diagram illustrating the method of forming seed crystal substrate by epitaxial deposition on a sublimation method single crystal substrate.

### EMBODIMENTS OF THE INVENTION

Hereinafter, an embodiment of the present invention will be described with reference to the drawings. In the following descriptions and drawings, the same parts will be marked with the same reference sign, and parts that have been described once will be omitted or explained only to the extent necessary.

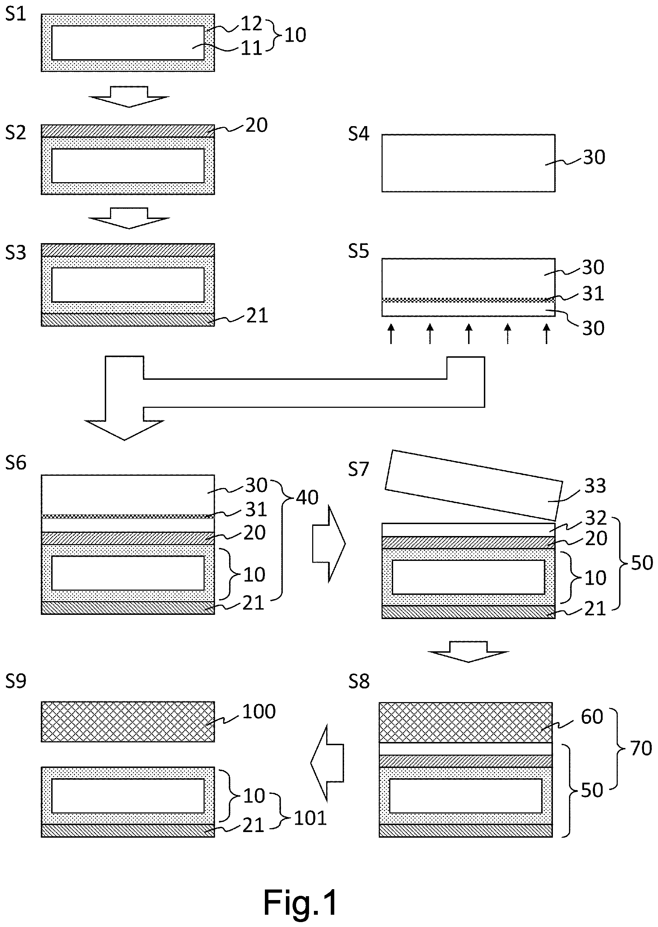

Fig. 1 is a diagram showing the flow of the method for manufacturing group-III nitride single crystal substrate 100 of the present invention.

First, a support substrate 10 containing nitride ceramics is prepared (support substrate preparation step S1). The support substrate 10 is one in which an encapsulating layer 12 is formed around a core 11.

As the material of the core 11, AlN, GaN, or Si₃N₄ nitride ceramics that have high thermal conductivity and a thermal expansion coefficient as close as possible to that of the Group III nitride single crystal substrate 100 to be manufactured are suitable.

The encapsulating layer 12 is formed to wrap around the core 11 in order to seal impurities such as metals and carbon that diffuse from the ceramics of the core 11.

The encapsulating layer 12 may contain either or both silicon nitride (Si₃N₄) and silicon oxynitride (SiOₓN_{y}), which have good affinity with the ceramics of the core 11 and high impurity blocking ability. When SiOₓN_{y} is used, x = 1 and 1 ≤ y ≤ 20 are suitable from the viewpoint of balance with affinity to core 11 and impurity-blocking ability.

The thickness of the encapsulating layer 12 is preferably 0.05 µm or more and 1.5 µm or less. This is because if the thickness is less than 0.05 µm, the impurity-blocking ability is insufficient, and if the thickness exceeds 1.5 µm, the thermal expansion coefficient difference between the nitride ceramics and the encapsulating layer is large, and the layers tend to delaminate.

The encapsulating layer 12 may be formed by deposition using the LPCVD method, for example.

Then, a planarizing layer 20 is formed on the top surface of the support substrate 10 (planarizing layer formation step S2). Thereby, the unevenness of the support substrate 10 is flattened.

The planarizing layer 20 is formed by depositing either or both silicon dioxide (SiO₂) and silicon oxynitride (SiₓN_{y}) on the top surface of the support substrate 10 and further smoothing it to a surface precision that enables thin film transfer of a seed crystal layer 32. Smoothing may be performed, for example, by CMP polishing, etching, or the like.

When using SiₓN_{y} as the planarizing layer 20, 1 ≤ x ≤ 20 and y = 1 is suitable due to its affinity with the encapsulating layer 12, film formability on uneven surfaces, and ease of polishing and etching.

The deposition method of the planarizing layer 20 may be, for example, one of the plasma CVD method, LPCVD method, or low-pressure MOCVD method.

The thickness of the planarizing layer 20 is preferably 0.5 µm or more and 3.0 µm or less after polishing and etching. If the thickness is less than 0.5 µm, the unevenness of the support substrate 10 cannot be filled, resulting in voids, and if the thickness exceeds 3.0 µm, the thermal conductivity is reduced due to the thick SiO₂ and SiₓN_{y}, resulting in poor device characteristics.

In the present invention, if necessary, a stress adjusting layer 21 may be formed on the opposite side of the support substrate 10 from the side on which the planarizing layer 20 is formed (stress adjusting layer formation step S3). This stress adjusting layer 21 corrects warpage of a substrate 50 for epitaxial growth caused mainly by forming the planarizing layer 20. The stress adjusting layer 21 can also serve the function of crack prevention and electrostatic chucking. For the stress adjusting layer 21, a film material and thickness with a thermal expansion coefficient that enables correction of warpage of the substrate 50 for epitaxial growth are selected. Although not limited to a specific film material, it is preferred to include, for example, simple substance of silicon. The stress adjusting layer 21 may be deposited simultaneously with the planarizing layer 20.

Next, the seed crystal layer 32 is formed on the top surface of the planarizing layer 20. Prior to the formation, after selecting the material of a seed crystal substrate 30 from which the seed crystal layer 32 will be cut (seed crystal substrate preparation step S4), ions are implanted on one side (ion implantation surface) of the seed crystal substrate 30 to form a peeling position (an embrittlement layer) 31 in the seed crystal substrate 30 (ion implantation step S5). For example, H⁺, H₂⁺, Ar⁺, and He⁺ are suitable as the ions to be implanted.

The thickness of the seed crystal layer 32 is preferably 0.04 µm or more and 1.50 µm or less. If the thickness of the seed crystal layer 32 is less than 0.04 µm, it is too thin as a seed for epitaxial deposition, and its thickness and surface condition fluctuate greatly, making it difficult to obtain uniform epitaxial deposition on the entire surface. On the other hand, if the thickness of the seed crystal layer 32 exceeds 1.50 µm, the ion implantation depth must be extremely deep, and the ion implanter for this purpose becomes huge, which causes safety and economic problems.

When the seed crystal substrate 30 is implanted with ions, the peeling position 31 is formed in the seed crystal substrate 30 and a damaged layer is generated, resulting in degradation of crystallinity, loss of crystallinity (amorphization), or the like. Thus, after separating the seed crystal layer 32 from the seed crystal substrate 30, polishing and/or etching or other processes are usually required to remove the damaged layer. Therefore, the ion implantation depth should be determined by considering the desired thickness of the seed crystal layer 32 and the thickness of the damaged layer to be removed.

The suitable materials for the seed crystal substrate 30 are Si <111> single crystal, SiC single crystal, sapphire single crystal, or group III nitride single crystal such as aluminum nitride, aluminum gallium nitride, or GaN. This is because good crystal cannot be obtained by epitaxial growth unless the seed crystal has the same or similar crystal system as the target group III nitride single crystal, and the lattice constant and thermal expansion coefficient of the seed crystal are as close to those of the target single crystal as possible.

From the viewpoint of cost reduction, it is preferable to select large diameter Si <111> single crystal, SiC single crystal, or sapphire single crystal that are in mass production. Among these, Si <111> single crystal is more preferable because it is the most mass producible and large-diameter, high-quality, and relatively inexpensive. In addition, a Si <111> single crystal with a resistivity of 100 Ω-cm or higher at 20°C are most preferred. This is because when the resistivity of the Si <111> single crystal of the seed crystal at 20°C is 100 Ω-cm or higher, the effect of the diffusion of doped materials in Si on the manufactured group III nitride single crystal substrate 100 is hardly seen, and the power consumption at high frequencies of high frequency devices made from this substrate is low. Conversely, if the resistivity of Si <111> single crystal at 20°C is less than 100 Q-cm, the diffusion of doped material in Si is observed in the manufactured group III nitride single crystal substrate 100, and high frequency devices made from this substrate will consume more power at high frequency.

On the other hand, if aluminum nitride or gallium nitride single crystal, or the like, which is still difficult to obtain in large diameters, is selected, a substrate obtained by epitaxial deposition of aluminum nitride or gallium nitride crystals by the MOCVD or HVPE method using a large-diameter sapphire substrate as a base substrate may be used as the seed crystal substrate 30. If extremely high property is important, a substrate obtained by epitaxial deposition of aluminum nitride single crystal or gallium nitride single crystal, or the like by MOCVD method, HVPE method, or THVPE method with a substrate of sublimation method single crystal or AlN single crystal of small diameter as the base substrate may be used as the seed crystal substrate 30.

In this case, the peeling positions may be formed in the epitaxial layer by implanting ions from the surface of the epitaxial layer formed by epitaxial deposition.

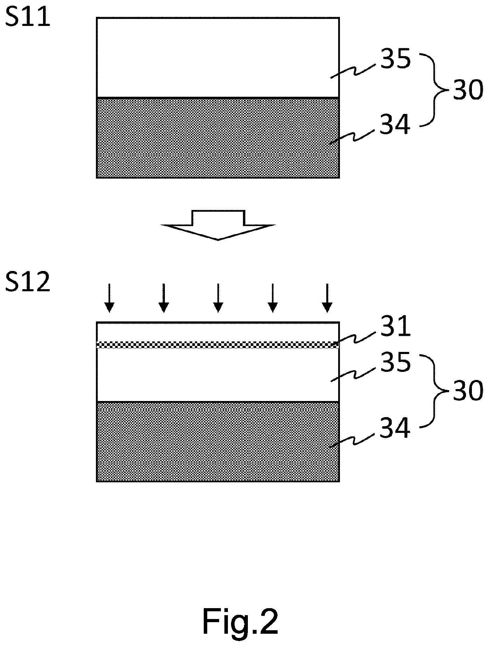

For example, as shown in Fig. 2, an AlN substrate 34 prepared by the sublimation method is used as the base substrate, and an epitaxial layer 35 of AlN is epitaxially deposited thereon by the MOCVD method, HVPE method, or THVPE method to form the seed crystal substrate 30 (step S11). Then, by implanting ions from the surface of the epitaxial layer 35 (ion implantation surface), the peeling position 31 of the seed crystal layer 32 can be formed in the epitaxial layer 35 (step S12).

According to such method, even if the expensive AlN substrate 34 made by sublimation method is used as the base substrate, a good quality seed crystal layer 32 can be formed economically and relatively fast, because only a part of the epitaxial layer 35 is consumed as the seed crystal layer 32. If the thickness of the epitaxial layer 35 is sufficient after the formation of the seed crystal layer 32, the seed crystal substrate 30 can be used repeatedly, and if the epitaxial layer 35 becomes thin due to repeated use of the seed crystal substrate 30, the thickness can be regained by performing epitaxial deposition again, thus it is effective in reducing manufacturing costs.

After preparing the seed crystal substrate 30 with implanted ions, the ion-implanted surface of the seed crystal substrate 30 and the planarizing layer 20 formed on the support substrate 10 are bonded to form the bonded body 40 (bonding step S6).

The bonded body 40 is then separated at the peeling position 31 (seed crystal layer formation step S7). This separates the substrate 50 for epitaxial growth, in which the seed crystal layer 32 is thinly transferred onto the planarizing layer 20 formed on the support substrate 10, and the remaining section 33 where the seed crystal layer 32 is removed from the seed crystal substrate 30. The remaining section 33 of the seed crystal substrate 30 can be reused as further seed crystal substrate.

The ion implantation surface of the seed crystal substrate 30 may be temporarily bonded to another temporary support substrate such as a silicon wafer, and then separated at the peeling position 31 to leave the seed crystal layer 32 bonded to the temporary support substrate. The seed crystal layer 32 on this temporary support substrate may then be bonded to the planarizing layer 20, and the temporary support substrate may be separated from the seed crystal layer 32 by an arbitrary method, thereby transferring the seed crystal layer 32 onto the planarizing layer 20. In this way, the substrate 50 for epitaxial growth can be formed in which the top and bottom of the seed crystal layer 32 bonded to the planarizing layer 20 is flipped.

Then, the target group III nitride single crystal is epitaxially grown on the top surface of the seed crystal layer 32 of the substrate 50 for epitaxial growth to the target thickness (epitaxial deposition step S8). Thereby, a composite substrate 70 of the target group III nitride single crystal is formed.

Then, by removing at least one of the planarizing layer 20 and the seed crystal layer 32 of the composite substrate 70 by melting using high frequency induction heating in inert gas under almost atmospheric pressure, or by dry etching with etching gas under reduced pressure heating, a layer 60 of the target group III nitride single crystal deposited on the substrate 50 for epitaxial growth is separated from the composite substrate 70 as a group III nitride single crystal substrate 100 (separation step S9). Specifically, for example, they are separated as follows.

In the case of the melting using high-frequency induction heating, the composite substrate 70 is first placed in a chamber apparatus that can rotate and move up and down, equipped with an induction coil and jig that can perform precise gradient heating. Then, after making the inside of the chamber apparatus an inert gas atmosphere such as Ar at about 1 atmospheric pressure, the induction coil and the jig are heated by applying high frequency by a high-frequency oscillator of 1 to 3 MHz so that the circumferential portion of the planarizing layer 20 and/or seed crystal layer 32 to be removed reaches a maximum temperature of 1300 to 1600°C. In this case, it is preferable to adjust the induction coil and jig so that the layer to be removed is thermally compensated so that its temperature does not decrease by thermal conduction while other parts of the layer are heated as little as possible. In addition, it is preferable to apply vertical tensile stress to the composite substrate 70 during heating. The reason for limiting the maximum temperature to the range of 1300-1600°C is that the layer to be removed does not melt at temperatures below 1300°C, and thermal degradation of the apparatus components is significant at temperatures exceeding 1600°C.

When dry etching with etching gas is used, the layer to be removed is etched by a gas that selectively etches the target layer, with heating from 300 to 1400°C. If the heating temperature is less than 300°C, etching at the junction between the substrate 50 for epitaxial growth and the layer 60 of group III nitride single crystal does not sufficiently proceed from the periphery to the interior. If the heating temperature exceeds 1400°C, the group III nitride single crystal may be etched significantly to layer 60 or damage apparatus components.

For more efficient etching, the dry etching rate may be increased by, for example, generating plasma by applying a high frequency of several hundred kHz to several tens of MHz while introducing etching gas into the layer to be removed at 950°C and under reduced pressure (several hundred mPa to several tens of Pa). The dry etching apparatus used in this case may be, for example, an ordinary reactive ion etching apparatus (RIE) or a high-density plasma etching apparatus (ECR, ICP) with equipment and fixtures modified to enable precise gradient heating.

The etching gas to be introduced should be selected depending on the layer to be removed. For example, if the seed crystal layer 32 is group III nitride-based, if the etching gas for the Si-based compound and the etching gas for the group III nitride do not react with each other, both the planarizing layer 20 and the seed crystal layer 32 can be removed by using a mixture of the etching gas for the Si-based compound and the etching gas for the group III nitride. On the other hand, if etching gases react intensely with each other when mixed, either the etching gas for Si-based compound or the etching gas for group III nitride can be used, but it is preferable to select an etching gas that can remove the planarizing layer 20, which is thicker than the seed crystal layer 32 and more effective in separation. Specifically, since the composition of the planarizing layer 20 is silicon dioxide (SiO₂) or silicon oxynitride (SiOₓN_{y}), an etching gas for the Si-based compound is suitable.

The etching gases for Si-based compound include perfluorogarbon (CF₄, C₂F₆, C₃F₈) , hydrofluorocarbons (CHF₃, CH₂F₂, CH3F, C₂H₂F₄) and the like. The etching gases for group III nitrides include inorganic halogen gases, hydrocarbon gases, and the like.

If necessary, additional gases such as H₂, O₂, He, Ar and the like may be added to these gases. The etching rate can be adjusted by changing the ratio of the added gas. If the seed crystal layer 32 is Si, for example, the etching rate can be increased by adding 10-20% O₂ to CF₄. If the planarizing layer 20 is SiO₂ and the seed crystal layer 32 is Si<111>, for example, 50% H₂ can be added to CF₄ when separating by removal of SiO₂, and the etching gas of CF₄ alone can be used when separating by removal of Si<111>.

If either melting by high frequency induction heating or dry etching by etching gas alone is not sufficient for separation, the other can be performed further to ensure more reliable separation.

If a part of the seed crystal layer 32 is adhered to the group III nitride single crystal substrate 100 when it is separated, it may be removed by a method appropriate for the composition of the seed crystal layer 32.

In addition, the remaining section 101 where the group III nitride single crystal substrate 100 is separated from the composite substrate 70 can be recycled and used as appropriate, thereby reducing manufacturing costs.

According to the method for manufacturing group-III nitride single crystal substrate of the present invention described above, group-III nitride single crystal substrate from which the hard and easily breakable support substrate part is removed by melting or etching can be obtained. Therefore, it is possible to avoid wasting manufacturing time and reducing the yield and property degradation due to device cracks caused by back-grinding of the support substrate part after device fabrication In addition, the remaining section removed from the composite substrate can be reused, thereby reducing manufacturing costs.

Furthermore, by optimizing the thickness of each layer comprising the composite substrate and the resistivity of the seed crystal layer, it is possible to prevent cracks and warpage of the group III nitride single crystal substrate that is separated from the composite substrate, as well as to prevent degradation of the characteristics of devices using group III nitride single crystal substrate.

Examples of the method for manufacturing group III nitride single crystal substrate and a comparative example are shown below.

### EXAMPLE 1

### (Preparation of support substrate)

After mixing 100 parts by weight of AlN powder and 5 parts by weight of Y₂O₃ as a sintering agent with organic binders and solvents to make green sheets, the sheets were degreased, sintered at 1900°C under N₂, and polished on both sides to produce a polycrystalline AlN substrate with a diameter of 8 inches and thickness of 725 µm. This polycrystalline AlN substrate was used as the core of the support substrate. The entire core was wrapped and covered with a silicon oxynitride layer of 0.4 µm thickness formed by LPCVD method, and then wrapped entirely with a silicon nitride (Si₃N₄) layer of 1.0 µm thickness formed using LPCVD apparatus. In this way,the support substrate in which the core is covered by the encapsulating layer of 1.4 µm thickness is formed.

### (Stacking of planarizing layer)

On the encapsulating layer on one side (top surface) of the support substrate, SiO₂ of 6 µm thickness was stacked by plasma CVD method (ICP-CVD apparatus) as the planarizing layer. The SiO₂ was then baked at 1000°C, and polished and planarized to a thickness of 3 µm by CMP polishing, resulting in a surface roughness of Ra = 0.14 nm.

### (Preparation of seed crystal)

A commercially available Si <111> substrate of 8 inches in diameter (resistivity of 150 Ω-cm at 20°C) raised by the CZ method was implanted with hydrogen ions at a dose of 6 × 10¹⁷/cm² at 100 keV to a depth of 0.7 µm (peeling position). Then, the ion implanted surface of the Si <111> substrate was bonded to the planarizing layer formed on the support substrate, and a thin film transfer was performed to form a Si <111> seed crystal layer on the support substrate. Portions of the seed crystal layer damaged during ion implantation and transfer were removed completely by etching after light polishing by CMP. The final thickness of the seed crystal layer was 0.04 µm. The remaining section of the Si <111> substrate after the transfer (i.e., the section that was separated without being thin film transferred to the support substrate) could be utilized as multiple seed crystals by repeatedly carrying out ion implantation, making it extremely economical. As a result, the substrate for epitaxial growth of 8 inches in diameter in which the planarizing layer of 3 µm thickness and Si <111> seed crystal layer of 0.04 µm thickness are provided on the support substrate with the AlN ceramic core encapsulated by the encapsulating layer was obtained.

### (GaN epitaxial deposition)

The substrates for epitaxial growth prepared as described above were then placed in a GaN epitaxial growth furnace (HVPE apparatus), and high-temperature nitridation at a substrate temperature of 900°C was performed for 30 minutes. A GaN buffer layer was then deposited at a substrate temperature of 400°C with a thickness of 20 nm, followed by epitaxial deposition of GaN to a thickness of 12 mm using GaCl₃ and NH₃ as process gases at a substrate temperature of 1050°C to obtain a GaN composite substrate.

### (Separation of GaN epitaxial deposition portion from composite substrate)

The GaN composite substrate prepared as described above was placed in a chamber apparatus that can be rotated and moved up and down, equipped with an induction coil and jig capable of precise gradient heating. Then, the inside of the apparatus was made to be an Ar gas atmosphere of about 1 atmospheric pressure, and the induction coil and jig were locally heated by applying 3 MHz high frequency to the induction coil and jig so that the circumferential portion of the seed crystal layer reached 1500 °C. At this time, the induction coil and jig were adjusted to ensure that the seed crystal layer was thermally compensated to prevent the seed crystal layer from temperature drop by thermal conduction, while other parts of the crystal were heated as little as possible. A slight tensile force was continuously applied to the top and bottom of the GaN composite substrate during heating. As a result, the GaN composite substrate could be separated into the GaN epitaxial deposition portion and the support substrate portion with a small amount of Si <111> seed crystal layer remaining.

### (Evaluation of GaN epitaxial deposition portion)

For crystal evaluation of the GaN epitaxial deposition portion, the GaN epitaxial deposition portion of 12 mm thick was cylindrically ground, cut to a thickness of 900 µm using a wire saw, rough polished, and CMP polished, resulting in five single crystal GaN substrates with final dimensions of 8 inches in diameter and 725 µm in thickness. The support substrate portion remaining after the GaN epitaxial deposition portion was separated was subjected to light CMP polishing on the separated side surface to remove the remaining portion of the Si<111> seed crystal layer, and then the Si<111> thin film was transferred again for recycling use.

The FWHM (Full Width at Half Maximum) of the X-ray rocking curves of the five evaluation GaN single crystal substrates with a diameter of 8 inches and a thickness of 725 µm obtained by the above processing varied slightly between the seed crystal side and the top side, but they had extremely excellent crystallinity of 291 to 350 arcsec. Etch pits were also generated by the solution alkaline (KOH + NaOH) etching method, and EPD (Etch Pit Density) was measured, showing an extremely low dislocation density of 2 × 10⁵/cm². Furthermore, a power device with 600 V breakdown voltage and an RF device for 28 GHz were made on these GaN single crystal substrates, and each device-fabricated substrate was thinned to 200 µm by back grinding on the back surface. The yields of the power devices with 600 V breakdown voltage and the RF devices for 28 GHz on these substrates, after cutting into individual devices, were extremely high, about 98% and 93%, respectively. The loss of the RF device at 28 GHz was as low as about 1.5 dB.

### Comparative Example

Epitaxial deposition of GaN was performed to a thickness of 35 µm under the same conditions as in Example 1, except that the resistivity at 20°C of the Si <111> substrate used to form the seed crystal layer was 85 Ω-cm, thereby obtaining GaN composite substrates with an approximate thickness of 760 µm. The obtained GaN composite substrate showed inferior crystallinity than Example 1, with the FWHM of 780 arcsec at the center of the x-ray rocking curve. The EPD was 8 × 10⁵/cm², a higher dislocation density than that of Example 1. Furthermore, a power device with 600 V breakdown voltage and an RF device for 28 GHz were fabricated on these GaN composite substrates in the same manner as in Example 1, and each device-fabricated substrate was thinned to 200 µm by back grinding on the back surface of the support substrate with the AlN ceramics core. Due to the hardness of the AlN ceramics core, the thinning process took 5 to 6 times longer than in Example 1, and cracking defects occurred in some places on the substrate with devices. Further, when attempting to cut the device-fabricated substrate into individual devices, there were many areas that could not be cut due to cracks in the device-fabricated substrate. Therefore, the yields of the power device with 600V breakdown voltage and the RF device for 28GHz were extremely low, at about 24% and 31%, respectively. The loss of the RF device at 28 GHz was very high, approximately 5.3 dB.

### EXAMPLE 2

### (Preparation of support substrate)

A commercially available GaN polycrystalline ceramic substrate with a metal impurity level of 4N and a diameter of 2 inches was prepared as the core of the support substrate. This entire core was wrapped and covered with silicon oxynitride (SiₓN_{y}, with an approximate average composition of x = 3 and y = 15), formed by LPCVD method with SiH₄ and N₂O gas, 0.06 µm thick, to form the support substrate.

### (Stacking of planarizing layer and stress adjusting layer)

A silicon oxynitride (SiₓN_{y}, with an approximate average composition of x = 17 and y = 2) layer of 1.3 µm thickness was formed by LPCVD method as the planarizing layer on the encapsulating layer on one side (top) of the support substrate. Then, it was polished to 0.5 µm thickness by CMP polishing. Since the entire substrate warped by about 50 µm due to the formation of the planarizing layer, the stress adjusting layer was formed on the bottom surface of the support substrate by LPCVD at a thickness of 0.5 µm having the same composition as the planarizing layer in order to correct the warpage. Furthermore, 0.05 µm of polycrystalline Si was added by using the LPCVD method so as to be compatible with attraction and desorption by an electrostatic chuck. As a result, the warpage was substantially eliminated, and attraction and desorption of the electrostatic chuck were possible.

### (Preparation of seed crystal)

A commercially available 2-inch diameter AlN single crystal (thickness: 280 µm) by sublimation (modified Lely method) was used as the base substrate, and epitaxial deposition of AlN was performed thereon by MOCVD method (reaction gas: trimethylaluminum (TMAI) + NH₃, carrier gas: N₂ and H₂) at 1050°C to obtain an epitaxial layer of 550 µm. Ion implantation was performed on the epitaxial layer at a depth of 1.6 µm, and the ion-implanted surface was bonded to the planarizing layer formed on the support substrate and then thin-film transferred to form an AlN seed crystal layer with a thickness of 1.6 µm on the support substrate. Portions of the seed crystal layer damaged during ion implantation and transfer were removed completely by etching after light polishing by CMP. The final thickness of the seed crystal layer, with damaged portions removed, was 1.4 µm. Through the process above, the substrate for epitaxial growth with a diameter of 2 inches was obtained with the planarizing layer of 0.5 µm thickness, the AlN seed crystal layer of 1.4 µm thickness, and the stress adjusting layer of 0.55 µm on the support substrate with the ceramic core of GaN encapsulated by the encapsulating layer.

### (AlN epitaxial deposition)

The substrate for epitaxial growth prepared as described above were then placed in an AlN epitaxial growth furnace (HVPE apparatus), and high-temperature nitridation at a substrate temperature of 900°C was performed for 30 minutes. Epitaxial deposition of AlN to a thickness of 10 mm using AlCl₃ and NH₃ as process gases at a substrate temperature of 1300°C was performed to obtain an AlN composite substrate.

### (Separation of AlN epitaxial deposition portion from composite substrate)

The AlN composite substrate prepared as described above was placed in a reactive ion etching (RIE) apparatus that can be rotated and moved up and down, equipped with an induction coil and jig capable of precise gradient heating. The temperature in the apparatus was then raised to 950°C, and etching of the planarizing layer was performed by introducing gas containing 10% of H₂ added to CF₄ as the etching gas for the planarizing layer (SiₓN_{y}) while maintaining a reduced pressure of 15 Pa. As a result, the AlN composite substrate could be separated into the AlN epitaxial deposition portion and the support substrate portion with a small amount of AlN seed crystal layer remaining.

### (Evaluation of AlN epitaxial deposition portion)

For crystal evaluation of the AlN epitaxial deposition portion, the AlN epitaxial deposition portion of 10 mm thick was cylindrically ground, cut to a thickness of 330 µm using a wire saw, rough polished, and CMP polished, resulting in five single crystal AlN substrates with final dimensions of 2 inches in diameter and 280 µm in thickness. The support substrate portion remaining after the AlN epitaxial deposition portion was separated was subjected to light CMP polishing on the separated side surface to remove the remaining portion of the AlN seed crystal layer, and then the AlN thin film was transferred again for recycling use.

The FWHM (Full Width at Half Maximum) of the X-ray rocking curves of the five evaluation AlN single crystal substrates with a diameter of 2 inches and a thickness of 280 µm obtained by the above processing varied slightly between the seed crystal side and the top side, but they had extremely excellent crystallinity of 189 to 280 arcsec. Etch pits were also generated by the solution alkaline (KOH + NaOH) etching method, and EPD (Etch Pit Density) was measured, showing an extremely low dislocation density of 0.1 × 10⁵/cm². Furthermore, LED devices were fabricated on these AlN single crystal substrates and thinned to 150 µm by back-grinding on the back surface. The yields of these substrates, after cutting into individual devices, were extremely high, about 99%.

The above embodiments and examples are examples only, and any configuration that is substantially the same as the technical concept described in the claims of the present invention and that produces similar effects is included in the technical scope of the present invention.

### REFERENCE SIGNS LIST

10 Support substrate
11 Core
12 Encapsulating layer
20 Planarizing layer
21 Stress adjusting layer
30 Seed crystal substrate
31 Peeling position
32 Seed crystal layer
33, 101 Remaining section
34 AlN substrate
35 Epitaxial layer
40 Bonded body
50 Substrate for epitaxial growth
60 Planarizing layer
70 Composite substrate
100 Single crystal substrate of group III nitride

## Claims

1. A method for manufacturing group III nitride single crystal substrate performing:
a support substrate preparation step for preparing a support substrate containing nitride ceramics;
a planarizing layer formation step for forming a planarizing layer on the top surface of the support substrate;
a seed crystal layer formation step for forming a seed crystal layer on the top surface of the planarizing layer;
an epitaxial deposition step for epitaxially growing a target group III nitride single crystal on the top surface of the seed crystal layer to form a composite substrate; and
a separation step for separating the group III nitride single crystal substrate made of the group III nitride single crystal from the remaining section of the composite substrate by removing at least one of the planarizing layer and the seed crystal layer.

2. The method for manufacturing group III nitride single crystal substrate according to claim 1, wherein the removal of at least one of the planarizing layer and the seed crystal layer is performed by melting using high-frequency induction heating.

3. The method for manufacturing group III nitride single crystal substrate according to claim 1, wherein the removal of at least one of the planarizing layer and the seed crystal layer is performed by dry etching with an etching gas for Si-based compound and/or an etching gas for group III nitride.

4. The method for manufacturing group III nitride single crystal substrate according to claim 1 further performs a stress adjusting layer formation step for forming a stress adjusting layer on the bottom surface of the support substrate.

5. The method for manufacturing group III nitride single crystal substrate according to claim 4, wherein the stress adjusting layer includes silicon.

6. The method for manufacturing group III nitride single crystal substrate according to claim 1, wherein the nitride ceramics is either AlN-based, GaN-based or Si₃N₄-based.

7. The method for manufacturing group III nitride single crystal substrate according to claim 1, wherein the support substrate has a structure in which the core consisting of nitride ceramics is wrapped in an encapsulating layer with a thickness of 0.05 µm or more to 1.5 µm or less.

8. The method for manufacturing group III nitride single crystal substrate according to claim 7, wherein the encapsulating layer includes at least one of Si₃N₄ and SiOₓN_{y} (where x = 1, 1 ≤ y ≤ 20).

9. The method for manufacturing group III nitride single crystal substrate according to claim 1, wherein the planarizing layer includes at least one of SiO₂ and SiOₓN_{y} (where , 1 ≤ x ≤ 20, y = 1) .

10. The method for manufacturing group III nitride single crystal substrate according to claim 1, wherein the thickness of the planarizing layer is 0.5 µm or more and 3.0 µm or less.

11. The method for manufacturing group III nitride single crystal substrate according to claim 1, wherein the thickness of the seed crystal layer is 0.04 µm or more and 1.50 µm or less.

12. The method for manufacturing group III nitride single crystal substrate according to claim 1, wherein the seed crystal layer is Si<111> single crystal.

13. The method for manufacturing group III nitride single crystal substrate according to claim 12, wherein resistivity at 20°C of the Si<111> single crystal is 100 Ωcm or more.

14. The method for manufacturing group III nitride single crystal substrate according to claim 1, wherein the seed crystal layer is a group III nitride single crystal.
